# EUROPÄISCHE PATENTSCHRIFT

(11) **EP 1 110 035 B1**
(45) Veröffentlichungstag und Bekanntmachung des Hinweises auf die Patenterteilung: **27.11.2002**
(21) Anmeldenummer: 99952359.0
(22) Anmeldetag: 11.08.1999
(51) Int. Cl.: F23L 1/00

(54) **VERFAHREN UND VORRICHTUNG ZUR STEUERUNG EINES ABSCHALTBAREN STROMRICHTERVENTILS MIT DER REIHENSCHALTZAHL ZWEI ODER GRÖSSER**
METHOD AND DEVICE FOR CONTROLLING A POWER CONVERTER VALVE THAT CAN BE TURNED OFF AND HAS A NUMBER OF SERIES CIRCUITS AMOUNTING TO TWO OR MORE
PROCEDE ET DISPOSITIF POUR COMMANDER UN ELEMENT D'OBTURATION DE CONVERTISSEUR POUVANT ETRE MIS HORS CIRCUIT ET PRESENTANT UN NOMBRE DE CIRCUITS EN SERIE SUPERIEUR OU EGAL A DEUX

(30) Priorität: 24.08.1998 DE 19838389
(43) Veröffentlichungstag der Anmeldung: 27.06.2001
(73) Patentinhaber: SIEMENS AKTIENGESELLSCHAFT, 80333 München (DE)
(72) Erfinder: BRUCKMANN, Manfred, D-90475 Nürnberg (DE); MARQUARDT, Rainer, D-85521 Ottobrunn/Riemerling (DE); SOMMER, Rainer, D-91336 Heroldsbach (DE)
(86) Internationale Anmeldenummer: DE9902506
(87) Internationale Veröffentlichungsnummer: WO00011407

(56) Entgegenhaltungen:
- EP-A- 0 653 830
- US-A- 5 379 178
- GERSTER C: "FAST HIGH-POWER/HIGH-VOLTAGE SWITCH USING SERIES-CONNECTED IGBTS WITH ACTIVE GATE-CONTROLLED VOLTAGE-BALANCING" PROCEEDINGS OF THE ANNUAL APPLIED POWER ELECTRONICS CONFERENCE AND EXPOSITION (APEC),US,NEW YORK, IEEE, Bd. CONF. 9, 1994, Seiten 469-472, XP000467353

## Beschreibung

Die Erfindung bezieht sich auf ein Verfahren und eine Vorrichtung zur Steuerung eines Stromrichterventils mit wenigstens zwei elektrisch in Reihe geschalteten abschaltbaren, nichteinrastenden Leistungshalbleiterschalter, die jeweils eine aktive Kollektor-Emitter-Begrenzungsschaltung aufweisen.

Zu den abschaltbaren, nichteinrastenden Leistungshalbleiterschaltern gehören beispielsweise **I**nsulated-**G**ate-**B**ipolar-**T**ransistor (IGBT), bipolare **L**eistungstransistoren (LTR), **M**etal-**O**xid-**S**emiconductor-**F**ield-**E**ffect-**T**ransistor (MOSFET) oder **H**ard-**D**riven **G**ate-**T**urn-**O**ff-**T**hyristor (HD GTO). Im Gegensatz zu den einrastenden Leistungshalbleiterschaltern, beispielsweise **G**ate-**T**urn-**O**ff-**T**hyristor (GTO), **M**OS-**C**ontrol-**T**hyristor (MCT) oder Thyristoren benötigen die nichteinrastenden Leistungshalbleiterschalter ständig ein Ansteuersignal um sicher ein- bzw. ausgeschaltet zu bleiben. Nachfolgend wird als nichteinrastender Leistungshalbleiterschalter nur noch der IGBT genannt, wodurch jedoch keine Einschränkung bezweckt werden soll.

Mit den derzeitig verfügbaren IGBT-Bauelementen (Modulen) sind Stromrichter im MV-Bereich ohne Parallelschaltung von Modulen realisierbar. Soll der Spannungsbereich und/oder der Leistungsbereich eines derartigen Stromrichters erhöht werden, so bietet sich die Reihenschaltung mehrerer IGBT-Modulen pro Stromrichterventil an. Eine derartige Stromrichterschaltung wird als Stromrichter mit einer Reihenschaltzahl Zwei oder größer bezeichnet.

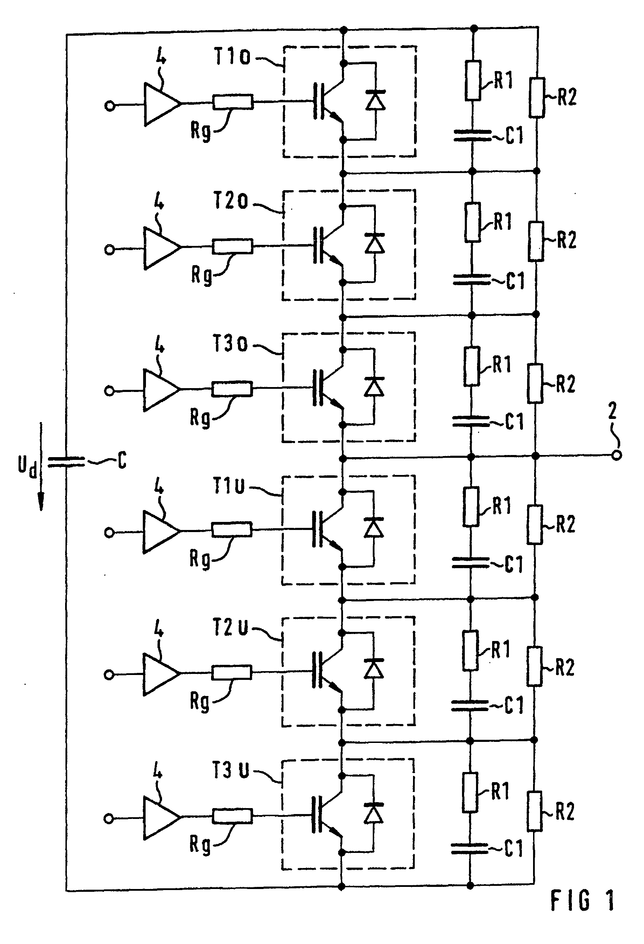

In der FIG 1 ist ein Prinzipschaltbild eines Stromrichters mit der Reihenschaltzahl Drei einer Phase eines mehrphasigen Stromrichters dargestellt. Diese Brückenschaltung weist drei obere und drei untere Leistungshalbleiterschalter T1o, T2o, T3o und T1u, T2u, T3u auf, die elektrisch in Reihe geschaltet sind. Der Verbindungspunkt der oberen und unteren Leistungshalbleiterschalter T1o, T2o, T3o und T1u, T2u, T3u bilden einen Phasenanschluß 2. Eingangsseitig ist dieser Phasen-Stromrichter mit einem Zwischenkreiskondensator C verknüpft, der die Zwischenkreis-Gleichspannung U_{d} stabilisiert. Jedem Leistungshalbleiterschalter T1o, T2o, T3o und T1u, T2u, T3u ist einem RC-Beschaltung, bestehend aus einem Kondensator C1 und einem Widerstand R1 und einem Symmetrierwiderstand R2, elektrisch parallel geschaltet. Jeder Leistungshalbleiterschalter T1o, T2o, T3o und T1u, T2u, T3u weist eine Vorrichtung zur Steuerung auf, von der hier aus Übersichtlichkeitsgründen nur eine Treiberstufe 4 mit nachgeschaltetem Gate-Widerstand Rg dargestellt sind. Jede dieser Vorrichtungen weist noch eine aktive Kollektor-Emitter-Begrenzungsschaltung auf. Ein derartiger Phasen-Stromrichter ist aus der Veröffentlichung mit dem Titel "High Power IGBT Converters with new Gate Drive and Protection Circuit" abgedruckt in EPE'95, Seiten 1.066 bis 1.070, bekannt.

Mittels der RC-Beschaltung werden jeweils der Effekt nichtlinearer Sperrschichtkapazitäten des IGBTs mit interner Invers-Diode minimiert. Mittels der Symmetrierwiderstände R2 wird eine gleichmäßige statische Spannungsaufteilung erreicht. Die aktiven Kollektor-Emitter-Begrenzungsschaltungen einer jeden Stufe begrenzt die maximale Spannung für jedes IGBT-Modul T1o, T2o, T3o, T1u, T2u, T3u unterhalb der zulässigen Blockierspannung.

Im Gegensatz zum Stromrichter mit der Reihenschaltzahl Eins sind bei einem Stromrichter mit Reihenschaltzahl Zwei und größer die möglichen Spannungspotentiale der einzelnen Leistungshalbleiterschalter a priori nicht fest vorgegeben.

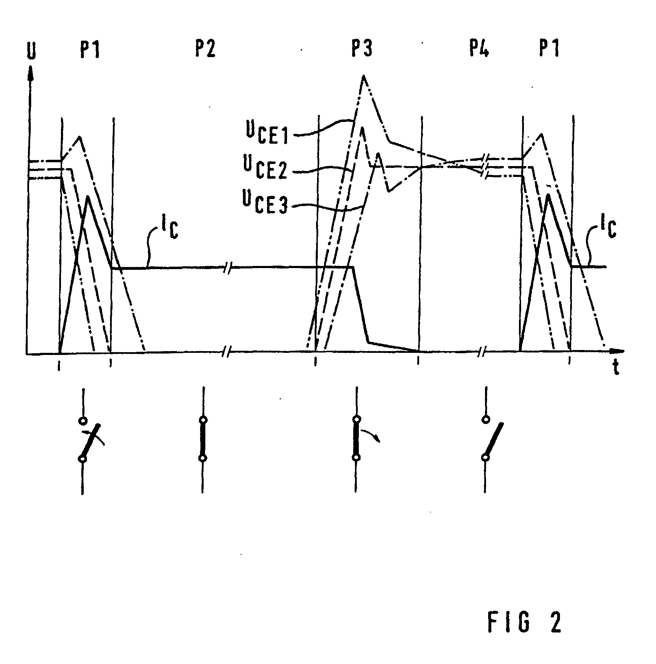

In der FIG 2 sind beispielhaft Spannungsverläufe der Kollektor-Emitter-Spannungen U_{CE1}, U_{CE2}, U_{CE3}, beispielsweise der Leistungshalbleiterschaltern T1o, T2o, T3o, während der Phasen "Einschalten" P1, "Leiten" P2, "Ausschalten" P3 und "Sperren" P4 über die Zeit t dargestellt.

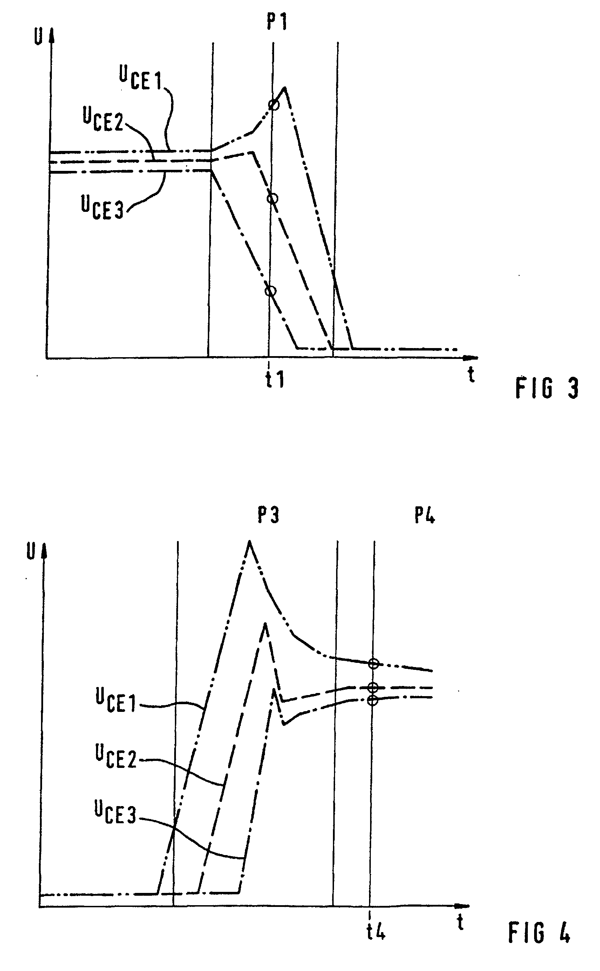

Während der Phasen Ein- bzw. Ausschalten P1 bzw. P3 (FIG 3 bzw. FIG 4) bestimmen vor allem halbleitereigene Eigenschaften, wie z.B. Unterschiede bezüglich Speicherladung und Sperrschichtkapazität, unterschiedliche Verzögerungen und Ein- bzw. Ausschaltzeiten, die Spannungsverteilung, aber auch Unterschiede in der Ansteuerung durch toleranz-, jitter- und driftbehaftete Signallaufzeiten sowie Eigenschaften im Lastkreis (Steuerinduktivitäten, Streu- und Erdkapazitäten und zusätzliche Beschaltungen) haben ein nicht zu vernachlässigen Einfluß. In der FIG 3 ist ein Zeitpunkt t1 gekennzeichnet, der aufzeigt, wie die Spannungsverteilung an den in Reihe geschalteten Leistungshalbleiterschaltern T1o, T2o, T3o während der Phase Einschalten P1 zu diesem Zeitpunkt t aussieht. Diesem Diagramm gemäß FIG 3 ist zu entnehmen, daß der Leistungshalbleiterschaltern T1o den größten Teil der Sperrspannung aufnimmt.

Während der Phase Sperren P4 (FIG 4) ist die Spannungsaufteilung nicht stabil, sondern vom vorhergehenden Ausschaltvorgang, dem abgeschalteten Strom und von der Größe, Toleranz und Drift des Leckstromes sowie von einer Beschaltung abhängig. Die Leckströme führen nach einer vom Sperrschicht- und Beschaltungskapazitäten abhängigen Zeit zu einer ungleichmäßigen stationären Spannungsaufteilung, bei welcher im ungünstigsten Fall ein einzelner Leistungshalbleiterschalter die gesamte Sperrspannung aufnehmen muß. Der Zeitpunkt t4 verdeutlicht in der FIG 4 einen Augenblick einer Spannungsverteilung im ausgeschalteten Zustand (Phase P4).

Aus der EP 0 653 830 B1 ist ein Verfahren und eine Vorrichtung zur Ansteuerung eines Stromrichters mit der Reihenschaltzahl Drei bekannt, mit dem die aufgezeigten Probleme gelöst werden. Bei diesem bekannten Verfahren werden die Kollektor-Emitter-Spannungen der elektrisch in Reihe geschalteten abschaltbaren, nichteinrastenden Leistungshalbleiterschalter und die gesamte über der Serienschaltung anliegende Spannung gemessen. Aus einem n-ten Teil der Gesamtspannung und jeweils einer Kollektor-Emitter-Spannung wird jeweils eine Differenzspannung ermittelt, aus der dann Ein- und Ausschaltzeiten berechnet werden. Mittels einer Verzögerungsschaltung und diesen Ein- und Ausschaltzeiten werden die Zeitschaltpunkte eines bereitgestellten Steuersignals für jeden Leistungshalbleiterschalter der Reihenschaltung ermittelt. Die Ein- und Ausschaltzeiten und die Schaltzeitpunkte eines Steuersignals werden so berechnet, daß alle Leistungshalbleiterschalter der Serienschaltung spannungsmäßig gleich belastet werden. Im ausgeschalteten Zustand der elektrisch in Reihe geschalteten Leistungshalbleiterschalter werden aus den gemessenen Kollektor-Emitter-Spannungen mit Hilfe eines n-ten Teils der Gesamtspannung jeweils die Höhe der einzelnen Steuersignale derart berechnet daß für alle Schalter eine gleiche Spannungsbelastung im gesperrten Zustand resultiert. Diese berechneten Schaltzeitpunkte werden erst beim darauffolgenden Schaltvorgang umgesetzt.

Aus der EP 0 666 647 A1 ist ein Verfahren und eine Schaltungsanordnung zur Ansteuerung von Halbleiterschaltern einer Reihenschaltung bekannt, wobei jedem Halbleiterschalter eine Spannungsbegrenzungsvorrichtung zugeordnet ist. Mit diesem bekannten Verfahren wird die Verlustleistung jeder Spannungsbegrenzungsvorrichtung durch eine Regeleinrichtung zur Vergleichmäßigung der Spannungsaufteilung über die Halbleiter erfaßt. Die Regeleinrichtung erzeugt aus einem gemeinsamen Steuerimpuls auf der Grundlage der erfaßten Verlustleistungen der Spannungsbegrenzungsvorrichtungen modifizierte Steuerimpulse für jeden Halbleiterschalter. Dadurch wird die Verlustleistung der Spannungsbegrenzungsvorrichtungen auf ein Minimum geregelt. In dieser europäischen Offenlegungsschrift ist eine Ausführungsform angegeben, bei der jedem halbleiterschalter eine RCD-Beschaltung, Symmetrierwiderstände und Kurzschlußelemente elektrisch parallel geschaltet sind. Die RCD-Beschaltung schützt das IGBT-Modul vor Überspannungsspitzen während des Abschaltens des Laststromes. Die Symmetrierwiderstände sorgen für eine stationäre Spannungsaufteilung und die Kurzschlußelemente, beispielsweise Avalange-Dioden bzw. Varistoren, übernehmen den Stromfluß, wenn die Module ausfallen und die Modulspannung die Ansprechschelle der Spannungsbegrenzungsvorrichtung und die höhere Ansprechschwelle der Kurzschlußelemente überschreitet.

Bei beiden bekannten Verfahren wird durch eine Verschiebung von Schaltzeitpunkten eines bereitgestellten Steuersignals eine symmetrische Spannungsaufteilung erreicht. Diese Symmetrierung der Spannungsaufteilung bei einem abschaltbaren Stromrichterventil mit einer Reihenschaltzahl Zwei oder größer erfolgt statisch und nicht dynamisch, da es sich um ein zeitdiskretes Verfahren handelt, d.h. in einem Schaltvorgang werden aus den gemessenen Ist-Werten Schaltzeiten berechnet, die jedoch erst im darauffolgenden Schaltvorgang umgesetzt werden. Somit wird ein bereits eingetretener Betriebszustand nachträglich Schrittweise verändert.

Der Erfindung liegt nunmehr die Aufgabe zugrunde, daß ein Verfahren und eine Vorrichtung zur Steuerung eines Stromrichterventils mit wenigstens zwei elektrisch in Reihe geschalteter abschaltbarer, nichteinrastender Leistungshalbleiterschalter angegeben wird, mit dem eine dynamische Symmetrierung der Spannungsaufteilung im Stromrichterventil erzielt werden kann.

Diese Aufgabe wird erfindungsgemäß mit den Merkmalen des Anspruchs 1 (Verfahren) bzw. der Ansprüche 11 bzw. 12 bzw. 13 (Vorrichtung) gelöst.

Dadurch, daß mit dem Empfang einer Anstiegsflanke eines Ansteuersignals von einem vorbestimmten Wert einer Referenzbegrenzerspannung auf einen niedrigeren Wert umgeschaltet wird, wird erreicht, daß sich die Spannungen der einzelnen elektrisch in Reihe geschalteten Leistungshalbleiterschalter mit dem Einschaltbefehl auf einen Bereich, der für eine Vergleichmäßigung der Einschaltverlustarbeiten garantiert, symmetrieren. Während des Abschaltvorgangs wird der Wert der Referenzspannung auf den vorbestimmten Wert wieder angehoben, damit diese Leistungshalbleiterschalter im ausgeschalteten Zustand gegen Spannungsspitzen aus einem Versorgungsnetz geschützt sind.

Die Ausgestaltung der erfindungsgemäßen Vorrichtung zur Steuerung einer Reihenschaltung mehrerer abschaltbarer, nichteinrastender Leistungshalbleiterschalter ist abhängig von der Ausgestaltung der verwendeten aktiven Kollektor-Emitter-Begrenzungsschaltung.

Wird als Kollektor-Emitter-Begrenzungsschaltung eine Klemmbeschaltung mit wenigstens zwei Zenerdioden verwendet, so ist wenigstens eine Zenerdiode mittels eines Schalters überbrückbar. Der Schalter wird in Abhängigkeit der Anstiegsflanke geschlossen.

Wird als aktive Kollektor-Emitter-Begrenzungseinrichtung ein Differenzverstärker mit einer Referenzspannungsquelle verwendet, so wird eine zweite Referenzspannungsquelle verwendet, die mittels eines Umschalters mit dem Referenz-Eingang des Differenzverstärkers verbindbar ist. Der Umschalter wird in Abhängigkeit der Anstiegsflanke eines bereitgestellten Ansteuersignals betätigt. Die zweite Referenzspannungsquelle liefert eine Referenzbegrenzerspannung mit einem niedrigeren Wert.

Eine weitere Möglichkeit besteht darin, daß bei der Verwendung eines Differenzverstärkers mit einer Referenzspannungsquelle eine steuerbare Stromquelle vorgesehen ist, die ausgangsseitig mit einem Istwert-Eingang des Differenzverstärkers verknüpfbar ist. In Abhängigkeit der Anstiegsflanke eines bereitgestellten Ansteuersignals wird die steuerbare Stromquelle ausgangsseitig mit dem Istwert-Eingang des Differenzverstärkers verbunden. Dadurch wird der Istwert der Kollektor-Emitter-Spannung derart bearbeitet, daß ein Differenzwert ermittelt wird, der gleich einem Differenzwert eines unveränderten Istwertes und eines verminderten Wertes einer Referenzbegrenzerspannung ist.

Mit diesen drei genannten Vorrichtungen für die Steuerung einer Reihenschaltung mehrerer Leistungshalbleiterschalter symmetrieren sich die Spannungen der einzelnen Leistungshalbleiterschalter mit dem Einschaltbefehl umgehend und nicht zuerst beim darauffolgenden Schaltvorgang. Dies wird auch ohne großen Aufwand erreicht. Außerdem kann jede handelsübliche Ansteuereinrichtung modifiziert werden, die eine der drei genannten Ausführungsformen einer aktiven Kollektor-Emitter-Begrenzerschaltung aufweist.

Bei einem vorteilhaften Verfahren wird im ausgeschalteten Zustand nach einem vorbestimmten Zeitintervall nach Beendigung des Abschaltvorgangs zyklisch die vorbestimmte Referenzbegrenzerspannung für ein vorbestimmtes Zeitintervall um einen vorbestimmten Wert erniedrigt. Dadurch wird einem aufgrund unterschiedlicher Sperrströme bzw. unterschiedlicher Tailströme entstandene unsymmetrische Spannungsaufteilung symmetriert. Das heißt, die statische Symmetrierung erfolgt ebenfalls aktiv über das Ansteuerverfahren. Somit kann auf die Symmetrierwiderstände verzichtet werden.

Bei einem weiteren vorteilhaften Verfahren wird im ausgeschalteten Zustand nach einem vorbestimmten Zeitintervall nach Beendigung des Abschaltvorgangs eine ermittelte Gate-Emitter-Istspannung derart mit einer vorbestimmten Gate-Emitter-Referenzspannung verglichen, daß beim Überschreiten der Gate-Emitter-Referenzspannung der vorbestimmte Wert der Referenzbegrenzerspannung um einen vorbestimmten Wert abgesenkt wird. Mit diesem weiteren vorteilhaften Verfahren wird ebenfalls aktiv die statische Symmetrierung erreicht.

Das zyklische Verfahren ist eine prophylaktische Maßnahme, um im ausgeschalteten Zustand eine statische Symmetrierung zu erreichen. Das vorteilhafte weitere Verfahren tritt nur dann in Aktion, wenn eine Unsymmetrierung auftritt, die mittels der Gate-Emitter-Spannung ermittelt werden kann. Somit wird nur dann der Wert der vorbestimmten Referenzbegrenzerspannung abgesenkt, wenn eine Spannungsfehlverteilung auftritt und nur dann.

Bei einem weiteren vorteilhaften Verfahren wird die zyklische Verminderung des Wertes der Referenzbegrenzerspannung bei einer Reihenschaltung mehrerer Leistungshalbleiterschalter von Schalter zu Schalter zeitversetzt durchgeführt. Durch diese Zeitversetzung wird vermieden, daß die Sperrfähigkeit der Reihenschaltung wesentlich reduziert wird.

Weitere vorteilhafte Ausgestaltungen des Verfahrens sind den Unteransprüchen 5 bis 11 zu entnehmen, wobei die vorteilhaften Ausgestaltungen der Vorrichtung den Unteransprüchen 15 bis 17 zu entnehmen sind.

Zur näheren Erläuterung der Erfindung wird auf die Zeichnung Bezug genommen, in der mehrere Ausführungsbeispiele der Vorrichtung zur Steuerung eines Stromrichterventils mit wenigstens zwei elektrisch in Reihe geschalteten Leistungshalbleiter schematisch veranschaulicht sind.
- FIG 1: zeigt ein Prinzipschaltbild eines bekannten Stromrichters mit der Reihenschaltzahl Drei, in der
- FIG 2: sind Spannungsverläufe verschiedener Betriebszustände der Kollektor-Emitter-Spannungen der elektrisch in Reihe geschalteten Leistungshalbleiterschaltern gemäß FIG 1 in einem Diagramm über die Zeit t veranschaulicht, die
- FIG 3: zeigt die Spannungsverläufe der elektrisch in Reihe geschalteten Leistungshalbleiterschalter beim Einschalten in einem Diagramm über die Zeit t, die
- FIG 4: zeigt die Spannungsverläufe der elektrisch in Reihe geschalteten Leistungshalbleiterschaltern beim Ausschalten in einem Diagramm über der Zeit t, in den
- FIG 5 bis 7: sind mehrere Ausführungsformen der erfindungsgemäßen Vorrichtung zur Steuerung eines Stromrichterventils mit der Reihenschaltzahl Drei gemäß FIG 1 dargestellt, in den
- FIG 8 bis 13: sind die relevanten Signalverläufe der erfindungsgemäßen Vorrichtung jeweils in einem Diagramm über der Zeit t dargestellt, in den
- FIG 14 bis 17: sind die relevanten Signalverläufe eines vorteilhaften erfindungsgemäßen Verfahrens jeweils in einem Diagramm über der Zeit t dargestellt und die
- FIG 18: zeigt eine vorteilhafte Ausführungsform der erfindungsgemäßen Vorrichtung zur Steuerung eines Stromrichterventils mit der Reihenschaltzahl Zwei oder größer.

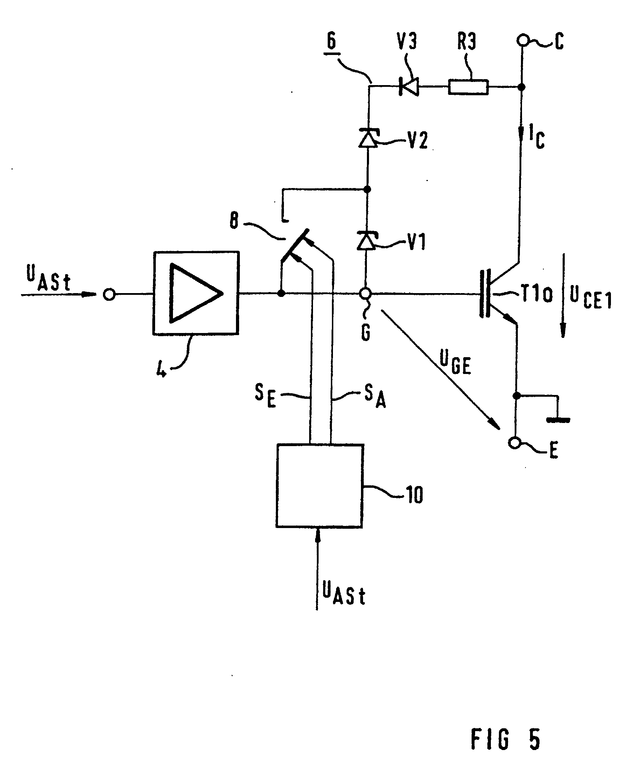

In der FIG 5 ist eine erste Ausführungsform der erfindungsgemäßen Vorrichtung zur Steuerung eines abschaltbaren, nichteinrastenden Leistungshalbleiterschalters T1o eines Stromrichterventils mit der Reihenschaltzahl Drei gemäß FIG 1 dargestellt. Die beiden anderen Leistungshalbleiterschalter T2o und T3o dieses Stromrichterventils mit der Reihenschaltzahl Drei sind der Übersichtlichkeit halber hier nicht dargestellt. Jedoch weist jeder abschaltbare, nichteinrastende Leistungshalbleiterschaltern T1o, T2o, T3o bzw. T1u, T2u, T3u eines Stromrichterventils mit der Reihenschaltzahl Drei gemäß FIG 1 eine in dieser FIG 5 dargestellten erfindungsgemäßen Vorrichtung auf.

Bei dieser ersten Ausführungsform ist eine Klemmbeschaltung 6 als aktive Kollektor-Emitter-Begrenzerschaltung vorgesehen. Diese Klemmbeschaltung 6 ist zwischen einem Kollektor-Anschluß C und einem Steueranschluß G des Leistungshalbleiterschalters T1o geschaltet. Diese Klemmbeschaltung 6 weist wenigstens zwei Zener-Dioden V1, V2, eine Entkopplungsdiode V3 und einen Strombegrenzungs-Widerstand R3 auf. Diese Zenerdioden V1 und V2 sind so bemessen, daß die im störungsfreien Schaltbetrieb anstehende Spitzenspannung U_{CE} kleiner ist als die Durchbruchsspannung des Leistungshalbleiterschalters T1o. Erreicht die Kollektor-Emitter-Spannung U_{CE1} des Leistungshalbleiterschalters T1o beim Ausschalten aus irgendeinem Grund annähernd die Durchbruchsspannung, so sprechen die Zenerdioden V1 und V2 an und ein stationärer Strom fließt durch diese Zenerdioden V1 und V2. Der Strom wird begrenzt durch den Strombegrenzungswiderstand R3. Durch diesen stationären Stromfluß zwischen Kollektor-Anschluß C und Steueranschluß G des Leistungshalbleiterschalters T1o wird dieser soweit angesteuert, daß die Kollektor-Emitter-Spannung U_{CE1} gleich der Summe der Zener-Spannungen der Zenerdioden V1 und V2 ist. In der DE 44 28 675 A1 und der DE 44 28 674 A1 ist jeweils eine Klemmbeschaltung 6 als aktive Kollektor-Emitter-Begrenzerschaltung und deren vorteilhaften Weiterbildungen ausführlich beschrieben, so daß an dieser Stelle auf eine ausführliche Beschreibung dieser Klemmbeschaltung 6 verzichtet werden kann.

Gemäß der Erfindung ist wenigstens eine Zenerdiode V1 bzw. V2 hier die Zenerdiode V1 mittels eines Schalters 8 überbrückbar. Am Steuereingang dieses Schalters 8 steht ein aus einem bereitgestellten Ansteuersignal U_{ASt} abgeleitetes Steuersignal S_{E}, S_{A} an. In Abhängigkeit der Anstiegsflanke wird dieser Schalter 8 mittels des Steuersignals S_{E} geschlossen.

Dadurch verringert sich sprungförmig der Wert der Referenzbegrenzerspannung U_{CEref}. Je mehr Zenerdioden V1, V2 verwendet werden, bei einer derartigen Klemmbeschaltung 6, um so feinstufiger wird die Verminderung des Wertes der Referenzbegrenzerspannung U_{CEref} für die Kollektor-Emitter-Spannung U_{CE1} des Leistungshalbleiterschaltern T1o. Mittels eines Steuersignal S_{A} wird der Schalter 8 wieder geöffnet. Dieses Steuersignal S_{A} wird aus der Abstiegsflanke des bereitgestellten Ansteuersignals U_{ASt} abgeleitet. Diese Generierung der Steuersignal S_{E} und S_{A} erfolgt mittels einer Einrichtung 10, deren Ausführung von der Wahl des Schalters 8 abhängig ist.

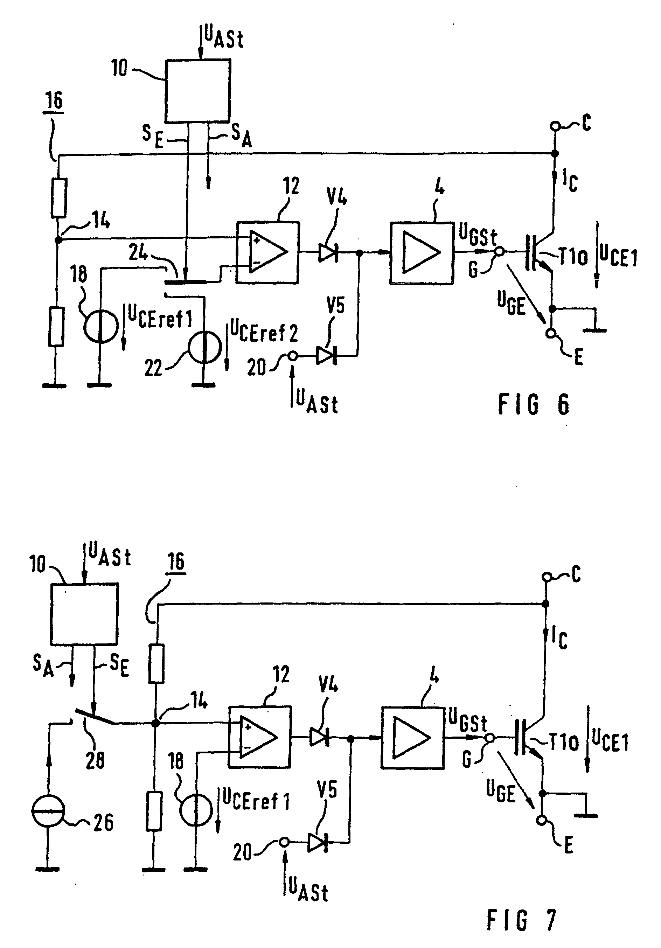

In der FIG 6 ist eine zweite Ausführungsform der erfindungsgemäßen Vorrichtung näher dargestellt. Bei dieser Ausführungform ist als aktive Kollektor-Emitter-Begrenzungsschaltung ein Differenzverstärker 12 vorgesehen. Der Istwert-Eingang "+" dieses Differenzverstärkers 12 ist mit einem Ausgang 14 eines Spannungsteilers 16 verknüpft, der einerseits mit dem Kollektor-Anschluß C des Leistungshalbleiterschalters T1o und andererseits mit einem Bezugspotential (Erdpotential) verbunden ist. Der Referenz-Eingang "-" des Differenzverstärkers 12 ist mit einer Referenzspannungsquelle 18 verbunden, die eine vorbestimmte Referenzbegrenzerspannung U_{CEref1} liefert. Ausgangsseitig ist dieser Differenzverstärker 12 mittels einer Entkopplungsdiode V4 mit einem Signaleingang der nachfolgenden Treiberstufe 4 verknüpft. Ein Steuereingang 20 ist ebenfalls mit einer Entkopplungsdiode V5 mit dem Signaleingang der Treiberstufe 4 verbunden. Eine Ausführungsform dieser Ansteuervorrichtung ist in der EP 0 690 898 B1 dargestellt und ausführlich beschrieben, so daß hier nicht näher darauf eingegangen werden muß.

Gemäß der Erfindung ist eine zweite Referenzspannungsquelle 22 vorgesehen, die eine verminderte Referenzbegrenzerspannung U_{CEref2} liefert. Augangsseitig ist diese Referenzspannungsquelle 22 mit einem Eingang eines Umschalters 24 verbunden, an dessen zweiten Eingang der Ausgang der Referenzspannungsquelle 18 angeschlossen ist. Ausgangsseitig ist dieser Umschalter 24 mit dem Referenz-Eingang "-" des Differenzverstärkers 12 verknüpft.

In der FIG 7 ist eine weitere Ausführungsform der erfindungsgemäßen Vorrichtung zur Steuerung eines Stromrichterventils mit einer Reihenschaltzahl Zwei und größer dargestellt. Auch bei dieser Ausführungsform wird ein Differenzverstärker 12 mit einem Spannungsteiler 16 und einer Referenzspannungsquelle 18 als aktive Kollektor-Emitter-Begrenzerschaltung verwendet. Diese weitere Ausführungsform unterscheidet sich von der Ausführungsform gemäß FIG 6 dadurch, daß anstelle einer zweiten Referenzspannungsquelle 22 und eines Umschalters 24 hier eine gesteuerte Stromquelle 26 vorgesehen ist, die ausgangsseitig mittels eines Schalters 28 mit dem Ausgang 14 des Spannungsteilers 16 verbindbar ist. Die Steuersignale S_{E} und S_{A} des Schalters 28 werden ebenfalls mittels der Einrichtung 10 aus einem bereitgestellten Ansteuersignal U_{ASt} generiert. Mittels der gesteuerten Stromquelle 26 kann der Wert der Referenzbegrenzerspannung U_{CEref1} der Referenzspannungsquelle 18 beliebig herabgesetzt werden.

Anstelle einer Referenzspannungsquelle 18 kann auch ein weiterer Spannungsteiler vorgesehen sein, der die Zwischenkreis-Gleichspannung U_{d} (FIG 1) auf ein vorbestimmtes Referenzbegrenzerspannung U_{CEref1} herunterteilt. Ebenso kann die Referenzbegrenzerspannung U_{CEref2} mittels diesem Spannungsteiler erzeugt werden, wobei ein weiterer Spannungsteiler-Ausgang mittels des Umschalters 24 mit dem Referenz-Eingang "-" des Differenzverstärkers 12 verbindbar ist.

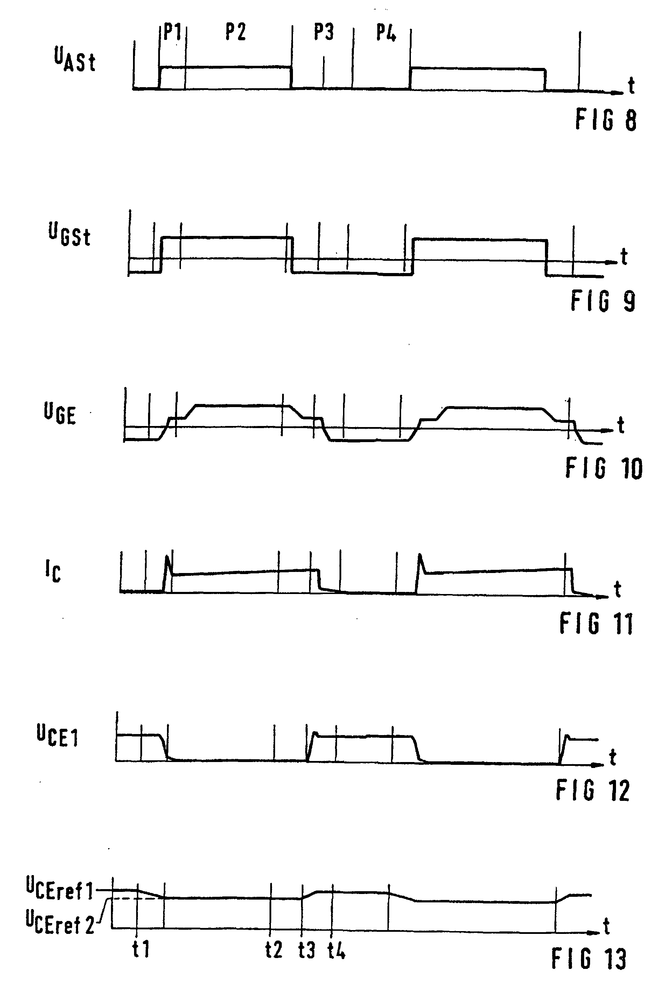

Anhand der Figuren 8 bis 13 wird die Funktionsweise der Vorrichtung gemäß FIG 6 näher erläutert.

Mit Eintreffen einer Anstiegsflanke eines bereitgestellten Ansteuersignals U_{ASt} zum Zeitpunkt t1 wird mittels eines Steuersignals S_{E} der Referenzeingang des Differenzverstärkers 12 anstelle mit dem Ausgang der Referenzspannungsquelle 18 mit dem Ausgang der Referenzspannungsquelle 22 verknüpft. Durch diesen Umschaltvorgang vermindert sich der Wert der vorbestimmten Referenzbegrenzerspannung U_{CEref1} am Referenzeingang des Differenzverstärkers 12 umgehend auf den verminderten Wert der Referenzbegrenzerspannung U_{CEref2}. Somit weist die aktive Kollektor-Emitter-Begrenzerschaltung einen neuen kleineren Sollwert auf, der für die Regelung der Kollektor-Emitter-Spannung U_{CE1} beim Einschalten verwendet wird. Durch diese sprungförmige Verminderung der Referenzbegrenzerspannung U_{CEref} vom Wert U_{CEref1} auf den niegrigeren Wert U_{CEref2} wird erreicht, daß die Einschaltverluste an den betreffenden Leistungshalbleiterschalter T1o beträchtlich reduziert wird. Außerdem symmetrieren sich die Spannungen U_{CE1}, U_{CE2} und U_{CE3} der in Reihe geschalteten Leistungshalbleiterschalter T1o, T2o und T3o des abschaltbaren Stromrichterventils gemäß FIG 1 mit dem Einschaltbefehl auf einen Bereich, der für eine Vergleichmäßigung der Einschaltverluste garantiert.

Es ist vorteilhaft, wie in FIG 13 veranschaulicht, den Wechsel vom vorbestimmten Wert U_{CEref1} der Referenzbegrenzerspannung U_{CEref} auf einen verminderten Wert U_{CEref2} der Referenzbegrenzerspannung U_{CEref} nicht sprungförmig, sondern mit einer Zeitfunktion (Rampe), zu bewältigen. Mittels dieser dynamischen Vorsteuerung lassen sich dynamische Unsymmetrieren reduzieren, wodurch sich die Einschaltverluste an den einzelnen Leistungshalbleiterschaltern T1o, T2o, T3o bzw. T1u, T2u, T3u des abschaltbaren Stromrichterventils gemäß FIG 1 wesentlich reduzieren.

Nachdem der Wert U_{CEref1} der Referenzbegrenzerspannung U_{CEref} auf den Wert U_{CEref2} der Referenzbegrenzerspannung U_{CEref} vermindet ist, verläuft die Einschaltphase wie bekannt ab.

Zum Zeitpunkt t2 weist das bereitgestellte Ansteuersignal U_{ASt} (FIG 8) eine Abstiegsflanke auf. Mit dieser Abstiegsflanke wird der Abschaltvorgang eingeleitet. Zum Zeitpunkt t3 wird die verminderte Referenzbegrenzerspannung U_{CEref2} wieder auf die vorbestimmte Referenzbegrenzerspannung U_{CEref1} angehoben. Auch diese Anhebung geschieht vorteilhafterweise zeitabhängig. Auch hier werden dadurch dynamische Unsymmetrieen reduziert. Die Anhebung der Referenzbegrenzerspannung U_{CEref} muß deshalb erfolgen, damit im gesperrten Zustand der Leistungshalbleiterschalter T1o gegen Überspannungen aus der anliegenden Eingangsspannung geschützt ist.

Die Anhebung der Referenzbegrenzerspannung U_{CEref} sollte dann beginnen, wenn der hochdynamische Teil des Abschaltvorgangs beginnt. Dieser Zeitpunkt ist dann erreicht, sobald der Leistungshalbleiterschalter entsättigt. Zu diesem Zeitpunkt ist die Gate-Emitter-Spannung U_{GE} auf die Plateau-Spannung abgesunken (FIG 10). Der Zeitpunkt t3 kann ebenfalls mit einer vorbestimmten Zeitspanne ermittelt werden, die mit Eintreffen der Abstiegsflanke des bereitgestellten Anstiegssignals U_{ASt} gestartet wird.

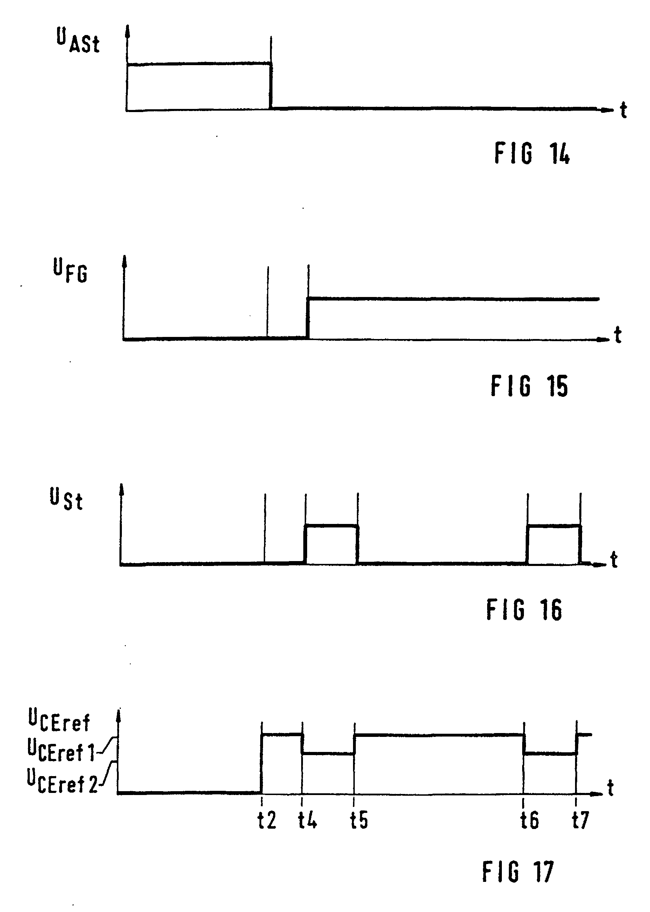

Anhand der Figuren 14 bis 17 wird die Funktionsweise der Vorrichtung gemäß FIG 7 näher erläutert, mit der ein vorteilhaftes Verfahren nach der Erfindung durchgeführt wird:

Eingangsseitig wurde darauf hingewiesen, daß infolge unterschiedlicher Restströme der elektrisch in Reihe geschalteter Leistungshalbleiterschalter T1o, T2o und T3o bzw. T1u, T2u und T3u sich eine unsymmetrische Spannungsaufteilung einstellt, die sich negativ beim nächsten Einschaltvorgang auswirken kann. Um diese unsymmetrische Spannungsaufteilung im gesperrten Zustand des Stromrichterventils mit einer Reihenschaltzahl Drei zu symmetrieren, wird die zuschaltbare steuerbare Stromquelle 26 während der Sperrphase des Leistungshalbleiterschalters T1o bzw. T2o bzw. T3o zeitzyklisch dem Signal-Eingang "+" des Differenzverstärkers 12 zugeschaltet. Diese zeitzyklische Zuschaltung der gesteuerten Stromquelle 26 erfolgt erst dann, wenn ein vorbestimmtes Zeitintervall t4-t2 nach Eintreffen der Abstiegsflanke des bereitgestellten Ansteuersignals U_{ASt} abgelaufen ist. Mit Ablauf dieses Zeitintervalles t4-t2 wird die zeitzyklische Absenkung der Referenzbegrenzerspannung U_{CEref} freigegeben (FIG 15). Mit Beginn des Freigabesignals U_{FG} wird für eine vorbestimmte Zeit t5-t4 (FIG 16) der vorbestimmte Wert U_{CEref1} der Referenzbegrenzerspannung U_{CEref} auf einen niedrigen Wert U_{CEref2} abgesenkt (FIG 17). Danach steigt der Wert der Referenzbegrenzerspannung U_{CEref} wieder auf den ursprünglichen Wert U_{CEref1} zurück. Zum Zeitpunkt t6 wiederholt sich dieser Vorgang. Das heißt, die Zeitspanne t6-t4 ergibt die Periodendauer dieser zeitzyklischen Absenkung der Referenzbegrenzerspannung U_{CEref} an.

Bei einem vorteilhaften Verfahren der zylischen Verminderung der Referenzbegrenzerspannung U_{CEref} werden diese zylischen Verminderung bei den elektrisch in Reihe geschalteten Leistungshalbleiterschalter T1o, T2o, T3o bzw. T1u, T2u, T3u des abschaltbaren Stromrichterventils gemäß FIG 1 von Leistungshalbleiterschalter zu Leistungshalbleiterschalter zeitversetzt durchgeführt. Durch diese zeitversetzte zyklische Verminderung wird vermieden, daß die Sperrfähigkeit des abschaltbaren Stromrichterventils gemäß FIG 1 wesentlich vermindert.

Der Vorteil dieser zeitzyklischen bzw. zeitversetzten zeitzyklischen Absenkung der Referenzbegrenzerspannung U_{CEref} liegt darin, daß die Symmetrierwiderstände R2 (FIG 1) zur statischen Spannungssymmetrierung verzichtet werden kann.

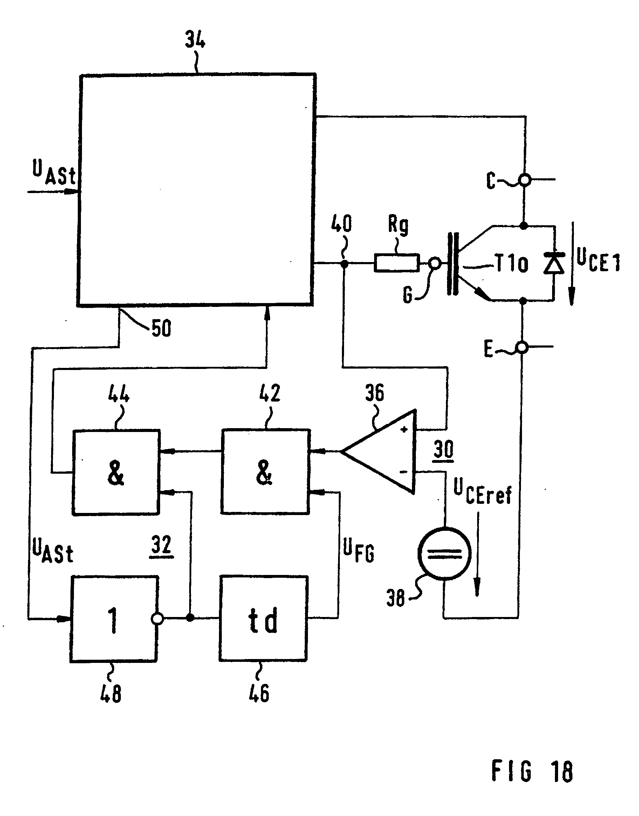

Die FIG 18 zeigt eine weitere vorteilhafte Vorrichtung zur Steuerung eines Stromrichterventils mit der Reihenschaltzahl Drei gemäß FIG 1. Diese Ausführungsform unterscheidet sich von der Ausführungsform gemäß FIG 6 dadurch, daß zusätzlich eine Gate-Emitter-Überwachungseinrichtung 30 und eine Logikschaltung 32 vorgesehen ist. Die Vorrichtung gemäß FIG 6 ist in dem Block 34 integriert.

Die Gate-Emitter-Überwachungseinrichtung 30 weist einen Differenzverstärker 36 und eine Referenzspannungsquelle 38 auf. Diese Referenzspannungsquelle 38 ist einerseits mit dem Emitter-Anschluß E des Leistungshalbleiterschalters T1o und andererseits mit dem invertierenden Eingang des Differenzverstärkers 36 verknüpft. Der nichtinvertierende Eingang dieses Differenzverstärkers 36 ist mit dem Ausgang 40 des Blockes 34 verbunden.

Die Logikschaltung 32 weist zwei UND-Gatter 42, 44, ein Verzögerungsglied 46 und einen Invertierer 48 auf. Ein Signalausgang 50 des Blockes 34, an dem das bereitgestellte Ansteuersignal U_{ASt} ansteht ist mit dem Eingang des Invertierers 48 verbunden, dessen Ausgang einerseits mit dem Verzögerungsglied 46 und andererseits mit einem ersten Eingang des zweiten UND-Gatters 44 verknüpft sind. Ausgangsseitig ist das Verzögerungsglied 46, dessen Verzögerungszeit td einstellbar ist, mit einem ersten Eingang des ersten UND-Gatters 42 verbunden. Der zweite Eingang dieses UND-Gatters 42 ist mit dem Ausgang des Differenzverstärkers 36 verknüpft, wobei der Ausgang des UND-Gatters 42 mit dem zweiten Eingang des zweiten UND-Gatters 44 verbunden ist. Die Verzögerungszeit td ist so eingestellt, daß ein Freigabesignal U_{FG} gemäß FIG 15 zum Zeitpunkt t4 ansteht.

Am Ausgang des Invertierers 48 wechselt der Zustand von Low nach High sobald die Abfallsflanke des bereitgestellten Ansteuersignal U_{ASt} eintrifft. Nach FIG 14 ist dies zum Zeitpunkt t2. Dieses High-Signal wird mittels des Verzögerungsgliedes 46 bis zum Zeitpunkt t4 (FIG 15) verzögert. Nach diesem Zeitpunkt t4 steht jeweils am ersten Eingang der nacheinander geschalteten UND-Gatter 42, 44 ein High-Signal an. Wenn nun die Gate-Emitter-Spannung U_{GE} im gesperrten Zustand des Leistungshalbleiterschaltern T1o den vorbestimmten Gate-Emitter-Referenzwert U_{GEref} übersteigt, so wechselt der Ausgang des Differenzverstärkers 36 seinen Zustand von Low nach High. Mit dieser Zustandsänderung des Differenzverstärkers 36 wechseln nun auch die Zustände der Ausgänge der beiden UND-Gatter 42 und 44. Somit steht am Ausgang des zweiten UND-Gatters 44 ein High-Signal an, das dem Block 34 zugeführt wird. Dieses High-Signal bewirkt die Reduzierung der vorbestimmten Referenzbegrenzerspannung U_{CEref}.

Dieses Schaltung wird erst dann aktiv, wenn eine unsymmetrische Spannungsaufteilung während eines Sperrzustandes des Leistungshalbleiterschalters T1o auftritt. Die Vorrichtung gemäß FIG 7 mit der zeitzyklischen Absenkung der Referenzbegrenzerspannung U_{CEref} ist eine prophylaktische Maßnahme und ist während des gesamten Sperrzustandes des Leistungshalbleiterschaltern T1o aktiv.

Bei einer Diodenreihenschaltung, wie sie beispielsweise in einer Chopperschaltung vorliegt, wird ein abschaltbares Stromrichterventil kleiner Leistung der Diodenreihenschaltung elektrisch parallel geschaltet. Dabei weist das Stromrichterventil eine zur Anzahl der Dioden korrespondierende Anzahl nichteinrastender Leistungshalbleiterschalter auf, die elektrisch in Reihe geschaltet sind.

Mit dem erfindungsgemäßen Verfahren wird erreicht, daß sich eine symmetrische Spannungsverteilung an der Diodenreihenschaltung einstellt. Mit dieser Schaltungsanordnung und dem erfindungsgemäßen Verfahren wird ein sicherer Überspannungsschutz für die Dioden der Diodenreihenschaltung erreicht.

## Patentansprüche

1. Verfahren zur Steuerung eines Stromrichterventils mit wenigsten zwei elektrisch in Reihe geschalteten abschaltbaren, nichteinrastenden Leistungshalbleiterschaltern (T1o, T2o, T3o; T1u, T2u, T3u), die jeweils eine aktive Kollektor-Emitter-Begrenzungsschaltung mit einer vorbestimmten Referenzbegrenzerspannung (U_{CEref}) aufweisen, wobei bei Eintreffen einer Anstiegsflanke eines Ansteuersignals (U_{ASt}) vom vorbestimmten Wert (U_{CEref1}) der Referenzbegrenzerspannung (U_{CEref}) auf einen niedrigeren Wert (U_{CEref2}) umgeschaltet wird, und wobei während eines Abschaltvorgangs (P3) wieder auf den vorbestimmten Wert (U_{CEref1}) der Referenzbegrenzerspannung (U_{CEref}) umgeschaltet wird.

2. Verfahren nach Anspruch 1, wobei im ausgeschalteten Zustand (P4) nach einem vorbestimmten Zeitintervall (t4-t2) nach Beendigung des Abschaltvorgangs (P3) zyklisch der vorbestimmte Wert (U_{CEref1}) der Referenzbegrenzerspannung (U_{CEref}) für einen vorbestimmten Zeitintervall (t5-t4) auf einen niedrigeren Wert (U_{CEref2}) erniedrigt wird.

3. Verfahren nach Anspruch 1, wobei im ausgeschalteten Zustand (P4) nach einem vorbestimmten Zeitintervall (t4-t2) nach Beendigung des Abschaltvorgangs (P3) eine ermittelte Gate-Emitter-Spannung (U_{GE}) derart mit einer vorbestimmten Gate-Emitter-Referenzspannung (U_{GEref}) verglichen wird, daß beim Überschreiten der Gate-Emitter-Referenzspannung (U_{GEref}) der vorbestimmte Wert (U_{CEref1}) der Referenzbegrenzerspannung (U_{CEref}) auf einen niedrigeren Wert (U_{CEref2}) abgesenkt wird.

4. Verfahren nach Anspruch 1 oder 2, wobei die zyklische Verminderung des Wertes der Referenzbegrenzerspannung (U_{CEref}) bei den elektrisch in Reihe geschalteten Leistungshalbleiterschaltern (T1o, T2o, T3o; T1u, T2u, T3u) des abschaltbaren Stromrichterventils zeitversetzt durchgeführt wird.

5. Verfahren nach Anspruch 1, wobei die Anhebung des niedrigeren Wertes (U_{CEref2}) der Referenzbegrenzerspannung (U_{CEref}) auf den vorbestimmten Wert (U_{CEref1}) der Referenzbegrenzerspannung (U_{CEref}) startet, sobald jeweils ein abschaltbarer, nichteinrastender Leistungshalbleiterschalter (T1o, T2o, T3o; T1u, T2u, T3u) entsättigt.

6. Verfahren nach Anspruch 1, wobei die Anhebung des niedrigeren Wertes (U_{CEref2}) der Referenzbegrenzerspannung (U_{CEref}) auf den vorbestimmten Wert (U_{CEref1}) der Referenzbegrenzerspannung (U_{CEref}) startet, sobald der Wert einer ermittelten Gate-Emitter-Spannung (U_{GE}) auf den Wert einer Plateau-Spannung abgesunken ist.

7. Verfahren nach Anspruch 1, wobei die Anhebung des niedrigeren Wertes (U_{CEref2}) der Referenzbegrenzerspannung (U_{CEref}) auf den vorbestimmten Wert (U_{CEref1}) der Referenzbegrenzerspannung (U_{CEref}) startet, sobald eine vorbestimmte Wartezeit abgelaufen ist.

8. Verfahren nach einem der Ansprüche 1 bis 7, wobei der Wert der Referenzbegrenzerspannung (U_{CEref}) derart erniedrigt wird, daß die aktive Kollektor-Emitter-Begrenzungsschaltung der elektrisch in Reihe geschalteten abschaltbaren, nichteinrastenden Leistungshalbleiterschaltern (T1o, T2o, T3o; T1u, T2u, T3u) des abschaltbaren Stromrichterventils ansprechen.

9. Verfahren nach einem der Ansprüche 1, 5 bis 8, wobei der vorbestimmte Wert (U_{CEref1}) der Referenzbegrenzerspannung (U_{CEref}) kontinuierlich auf einen niedrigeren Wert (U_{CEref2}) der Referenzbegrenzerspannung (U_{CEref}) abgesenkt wird.

10. Verfahren nach einem der Ansprüche 1, 5 bis 8, wobei von einem niedrigeren Wert (U_{CEref2}) der Referenzbegrenzerspannung (U_{CEref}) kontinuierlich auf den vorbestimmten Wert (U_{CEref1}) der Referenzbegrenzerspannung (U_{CEref}) angehoben wird.

11. Verfahren nach einem der vorgenannten Ansprüche, wobei der niedrigere Wert (U_{CEref2}) der Referenzbegrenzerspannung (U_{CEref}) aus einer ermittelten Zwischenkreis-Gleichspannung (U_{d}) abgeleitet wird.

12. Vorrichtung zur Steuerung eines abschaltbaren Stromrichterventils mit wenigstens zwei elektrisch in Reihe geschalteten abschaltbaren, nicht einrastenden Leistungshalbleiterschaltern (T1o, T2o, T3o; T1u, T2u, T3u), die jeweils eine Treiberstufe (4) und eine Klemmbeschaltung (6) als aktive Kollektor-Emitter-Begrenzungsschaltung aufweisen, wobei diese Klemmbeschaltung (6) zwischen einem Kollektor- und einem Steueranschluss (C, G) eines zugehörigen Leistungshalbleiterschalters (T1o, T2o, T3o; T1u, T2u, T3u) geschaltet ist, wobei die Treiberstufe (4), an deren Steuereingang ein Ansteuersignal (U_{Ast}) ansteht, ausgangsseitig mit einem Gate-Anschluss (G) eines zugehörigen Leistungshalbleiterschalters (T1o, T2o, T3o; T1u, T2u, T3u) verknüpft ist, und wobei wenigstens eine Zenerdiode (V1, V2) mittels eines Schalters (8) überbrückbar ist, der steuerungsseitig mit einer Einrichtung (10) zur Generierung zweier Steuersignale (S_{E}, S_{A}) aus einem anstehenden Ansteuersignal (U_{Ast}) verknüpft ist, wobei das Steuersignal (S_{E}) zum Schließen des Schalters (8) aus einer Anstiegsflanke und das Steuersignal (S_{A}) zum Öffnen des Schalters (8) aus einer Abstiegsflanke des Ansteuersignals (U_{Ast}) abgeleitet sind.

13. Vorrichtung zur Steuerung eines abschaltbaren Stromrichterventils mit wenigstens zwei elektrisch in Reihe geschalteten abschaltbaren, nicht einrastenden Leistungshalbleiterschaltern (T1o, T2o, T3o; T1u, T2u, T3u), die jeweils eine Treiberstufe (4) und eine eine Spannungserfassungs-Einrichtung (16) aufweisende aktive Kollektor-Emitter-Begrenzungsschaltung aufweisen, wobei als aktive Kollektor-Emitter-Begrenzungsschaltung ein Differenzverstärker (12) vorgesehen ist, wobei die Spannungsverfassungs-Einrichtung (16) eingangsseitig mit einem Kollektor-Anschluss (C) eines zugeordneten Leistungshalbleiterschalters (T1o, T2o, T3o; T1u, T2u, T3u) und ausgangsseitig mit einem Istwert-Eingang des Differenzverstärkers (12) verknüpft ist, der ausgangsseitig mit einem Steuereingang der Treiberstufe (4) verbunden ist, wobei ein Referenz-Eingang des Differenzverstärkers (12) mittels eines Umschalters (24) mit einer ersten und zweiten Referenzspannungsquellen (18, 22) verbindbar ist, wobei am Steuereingang des Umschalters (24) ein Steuersignal (S_{E}, S_{A}) ansteht, und wobei das Steuersignal (S_{E}) zum Verbinden des Referenz-Eingangs des Differenzverstärkers (12) mit der zweiten Referenzspannungsquelle (22) aus einer Anstiegsflanke und das Steuersignal (S_{A}) zum Verbinden des Referenz-Eingangs des Differenzverstärkers (12) mit der ersten Referenzspannungsquelle (18) aus einer Abstiegsflanke eines am Steuereingang der Treiberstufe (4) anstehenden Ansteuersignal (U_{Ast}) abgeleitet sind.

14. Vorrichtung zur Steuerung eines abschaltbaren Stromrichterventils mit wenigstens zwei elektrisch in Reihe geschalteten abschaltbaren, nichteinrastenden Leistungshalbleiterschaltern (T1o, T2o, T3o; T1u, T2u, T3u), die jeweils eine Treiberstufe (4) und eine eine Spannungsverfassungs-Einrichtung (16) aufweisende aktive Kollektor-Emitter-Begrenzungsschaltung aufweisen, wobei als aktive Kollektor-Emitter-Begrenzungsschaltung ein Differenzverstärker (12) vorgesehen ist, wobei die Spannungserfassung-Einrichtung (16) eingangsseitig mit einem Kollektor-Anschluss (C) eines zugeordneten Leistungshalbleiterschalters (T1o, T2o, T3o; T1u, T2u, T3u) und ausgangsseitig mit einen Istwert-Eingang des Differenzverstärkers (12) verknüpft ist, der ausgangsseitig mit einem Steuereingang der Treiberstufe (4) verbunden ist, wobei ein Referenz-Eingang des Differenzverstärkers (12) mit einer Referenzspannungsquelle (18) verknüpft ist, wobei eine steuerbare Stromquelle (26) ausgangsseitig mittels eines Schalters (28) mit einem Istwert-Eingang des Differenzverstärkers (12) verbunden ist, und wobei dieser Schalter (28) steuerungsseitig mit einer Einrichtung (10) zur Generierung zweier Steuersignale (S_{E}, S_{A}) aus einem anstehenden Ansteuersignal (U_{Ast}) verknüpft ist, wobei das Steuersignal (S_{E}) zum Schließen des Schalters (28) aus einer Anstiegsflanke und das Steuersignal (S_{A}) zum Öffnen des Schalters (28) aus einer Abstiegsflanke des Ansteuersignals (U_{Ast}) abgeleitet sind.

15. Vorrichtung nach einem der Ansprüche 12 bis 14, wobei eine Gate-Emitter-Überwachungseinrichtung (30) und eine Logikschaltung (32) vorgesehen ist, die der Gate-Emitter-Überwachungsschaltung (32) vorgesehen ist, die der Gate-Emitter-Überwachungsschaltung (30) nahegeschaltet ist, wobei am Steuereingang dieser Logikschaltung (32) ein Ansteuersignal (U_{Ast}) und an seinem Steuerausgang ein Steuersignal für die aktive Kollektor-Emitter-Begrenzungsschaltung ansteht.

16. Vorrichtung nach Anspruch 13, wobei als Umschalter (24) ein Überblendregler vorgesehen ist.

## Claims

1. Method for controlling a power converter valve having at least two turn-off, non-latching power semiconductor switches (T1o, T2o, T3o; T1u, T2u, T3u), which are electrically connected in series and each have an active collector-emitter limiting circuit with a predetermined reference limiter voltage (U_{CEref}), whereby, when a rising edge of a drive signal (U_{ASt}) arrives, a changeover is made from the predetermined value (U_{CEref1}) of the reference limiter voltage (U_{CEref}) to a lower value (U_{CEref2}), and whereby a changeover is made back to the predetermined value (U_{CEref1}) of the reference limiter voltage (U_{CEref}) during a turn-off operation (P3).

2. Method according to Claim 1, whereby, in the switched-off state (P4) after a predetermined time interval (t4-t2) after the ending of the turn-off operation (P3), the predetermined value (U_{CEref1}) of the reference limiter voltage (U_{CEref}) is cyclically decreased to a lower value (U_{CEref2}) for a predetermined time interval (t5-t4).

3. Method according to Claim 1, whereby, in the switched-off state (P4) after a predetermined time interval (t4-t2) after the ending of the turn-off operation (P3), a determined gate-emitter voltage (U_{GE}) is compared with a predetermined gate-emitter reference voltage (U_{GEref}) in such a way that when the gate-emitter reference voltage (U_{GEref}) is exceeded, the predetermined value (U_{CEref1}) of the reference limiter voltage (U_{CEref}) is decreased to a lower value (U_{CEref2}).

4. Method according to Claim 1 or 2, whereby the cyclic reduction of the value of the reference limiter voltage (U_{CEref}) is carried out in a manner staggered over time in the case of the power semiconductor switches (T1o, T2o, T3o; T1u, T2u, T3u) of the turn-off power converter valve which are electrically connected in series.

5. Method according to Claim 1, whereby the increasing of the lower value (U_{CEref2}) of the reference limiter voltage (U_{CEref}) to the predetermined value (U_{CEref1}) of the reference limiter voltage (U_{CEref}) starts as soon as a respective turn-off, non-latching power semiconductor switch (T1o, T2o, T3o; T1u, T2u, T3u) desaturates.

6. Method according to Claim 1, whereby the increasing of the lower value (U_{CEref2}) of the reference limiter voltage (U_{CEref}) to the predetermined value (U_{CEref1}) of the reference limiter voltage (U_{CEref}) starts as soon as the value of a determined gate-emitter voltage (U_{GE}) has fallen to the value of a plateau voltage.

7. Method according to Claim 1, whereby the increasing of the lower value (U_{CEref2}) of the reference limiter voltage (U_{CEref}) to the predetermined value (U_{CEref1}) of the reference limiter voltage (U_{CEref}) starts as soon as a predetermined waiting time has elapsed.

8. Method according to one of Claims 1 to 7, whereby the value of the reference limiter voltage (U_{CEref}) is decreased in such a way that the active collector-emitter limiting circuit of the turn-off, non-latching power semiconductor switches (T1o, T2o, T3o; T1u, T2u, T3u) of the turn-off power converter valve which are electrically connected in series responds.

9. Method according to one of Claims 1, 5 to 8, whereby the predetermined value (U_{CEref1}) of the reference limiter voltage (U_{CEref}) is decreased continuously to a lower value (U_{CEref2}) of the reference limiter voltage (U_{CEref}).

10. Method according to one of Claims 1, 5 to 8, whereby an increase is effected from a lower value (U_{CEref2}) of the reference limiter voltage (U_{CEref}) continuously to the predetermined value (U_{CEref1}) of the reference limiter voltage (U_{CEref}).

11. Method according to one of the preceding claims, whereby the lower value (U_{CEref2}) of the reference limiter voltage (U_{CEref}) is derived from a determined intermediate-circuit DC voltage (U_{d}).

12. Apparatus for controlling a turn-off power converter valve having at least two turn-off, non-latching power semiconductor switches (T1o, T2o, T3o; T1u, T2u, T3u) which are electrically connected in series and each have a driver stage (4) and a clamping snubber (6) as active collector-emitter limiting circuit, whereby this clamping snubber (6) is connected between a collector terminal (C) and a control terminal (G) of an associated power semiconductor switch (T1o, T2o, T3o; T1u, T2u, T3u), whereby the driver stage (4) at the control input of which a drive signal (U_{ASt}) is present, is linked on the output side to a gate terminal (G) of an associated power semiconductor switch (T1o, T2o, T3o; T1u, T2u, T3u), and whereby at least one zener diode (V1, V2) can be bridged by means of a switch (8) which is linked on the control side to a device (10) for generating two control signals (S_{E}, S_{A}) from a drive signal (U_{ASt}) which is present, whereby the control signal (S_{E}) for closing the switch (8) is derived from a rising edge and the control signal (S_{A}) to open the switch (8) is derived from a rising edge of the drive signal (U_{ASt}).

13. Apparatus for controlling a turn-off power converter valve having at least two turn-off, non-latching power semiconductor switches (T1o, T2o, T3o; T1u, T2u, T3u) which are electrically connected in series and each have a driver stage (4) and an active collector-emitter limiting circuit having a voltage detection device (16), whereby a differential amplifier (12) is provided as the active collector-emitter limiting circuit, whereby the voltage detection device (16) is linked on the input side to a collector terminal (C) of an assigned power semiconductor switch (T1o T2o, T3o; T1u, T2u, T3u), and on the output side to an actual value input of the differential amplifier (12), which is connected on the output side to a control input of the driver stage (4), whereby a reference input of the differential amplifier (12) can be connected to a first and second reference voltage source (18, 22) by means of a changeover switch (24), whereby a control signal (S_{E}, S_{A}) is present at the control input of the changeover switch (24), and whereby the control signal (S_{E}) for linking the reference input of the differential amplifier (12) with the second reference voltage (22) is derived from a rising edge and the control signal (S_{A}) for linking the reference input of the differential amplifier (12) with the first reference voltage source (18) is derived from a rising edge of a drive signal (U_{ASt}) present at the control input of the driver stage (4).

14. Apparatus for controlling a turn-off power converter valve having at least two turn-off, non-latching power semiconductor switches (T1o, T2o, T3o; T1u, T2u, T3u) which are electrically connected in series and each have a driver stage (4) and an active collector-emitter limiting circuit having a voltage detection device (16), whereby a differential amplifier (12) is provided as the active collector-emitter limiting circuit, whereby the voltage detection device (16) is linked on the input side to a collector terminal (C) of an assigned power semiconductor switch (T1o T2o, T3o; T1u, T2u, T3u), and on the output side to an actual value input of the differential amplifier (12), which is connected on the output side to a control input of the driver stage (4), whereby a reference input of the differential amplifier (12) is linked to a reference voltage source (18), whereby a controllable current source (26) is connected on the output side to an actual value input of the differential amplifier (12) by means of a switch (28), and whereby this switch (28) is linked on the control side with a device (10) for generating two control signals (S_{E}, S_{A}) from a drive signal (U_{ASt}) which is present, whereby the control signal (S_{E}) for closing the switch (28) is derived from a rising edge and the control signal (S_{A}) for opening the switch (28) is derived from a rising edge of the drive signal (U_{ASt}).

15. Apparatus according to one of Claims 12 to 14, whereby a gate-emitter monitoring device (30) and a logic circuit (32) connected downstream of the gate-emitter monitoring circuit (30) are provided, whereby a drive signal (U_{ASt}) is present at the control input of this logic circuit (32) and a control signal for the active collector-emitter limiting circuit is present at its control output.

16. Apparatus according to Claim 13, whereby a fading regulator is provided as the changeover switch (24).

## Revendications

1. Procédé pour la commande d'une soupape de convertisseur comportant au moins deux interrupteurs à semiconducteur de puissance (T1o, T2o, T3o ; T1u, T2u, T3u) interruptibles, sans verrouillage et branchés électriquement en série, qui comportent chacun un circuit de limitation collecteur-émetteur actif ayant une tension de limitation de référence prédéterminée (U_{CEref}), dans lequel, à l'arrivée d'un front montant d'un signal de commande (U_{ASt}), on commute de la valeur prédéterminée (U_{CEref1}) de la tension de limitation de référence (U_{CEref}) à une valeur inférieure (U_{CEref2}) et dans lequel, pendant une opération de coupure (P3), on commute à nouveau sur la valeur prédéterminée (U_{CEref1}) de la tension de limitation de référence (U_{CEref}).

2. Procédé selon la revendication 1, dans lequel, à l'état coupé (P4), après un intervalle de temps prédéterminé (t4-t2) après la fin de l'opération de coupure (P3), on diminue de façon cyclique la valeur prédéterminée (U_{CEref1}) de la tension de limitation de référence (U_{CEref}) pour un intervalle de temps prédéterminé (t5-t4) à une valeur inférieure (U_{CEref2}).

3. Procédé selon la revendication 1, dans lequel, à l'état coupé (P4), après un intervalle de temps prédéterminé (t4-t2) après la fin de l'opération de coupure (P3), on compare une tension grille-émetteur (U_{GE}) déterminée à une tension de référence grille-émetteur (U_{GEref}) prédéterminée de telle sorte que, lors du dépassement de la tension de référence grille-émetteur (U_{GEref}), on diminue la valeur prédéterminée (U_{CEref1}) de la tension de limitation de référence (U_{CEref}) à une valeur inférieure (U_{CEref2}).

4. Procédé selon la revendication 1 ou 2, dans lequel, pour les interrupteurs à semiconducteur de puissance (T1o, T2o, T3o ; T1u, T2u, T3u), branchés électriquement en série, de la soupape de convertisseur interruptible, on met en oeuvre la diminution cyclique de la valeur de la tension de limitation de référence (U_{CEref}) avec un décalage dans le temps d'un interrupteur à l'autre.

5. Procédé selon la revendication 1, dans lequel l'élévation de la valeur inférieure (U_{CEref2}) de la tension de limitation de référence (U_{CEref}) à la valeur prédéterminée (U_{CEref1}) de la tension de limitation de référence (U_{CEref}) commence dès que, respectivement, un interrupteur à semiconducteur de puissance interruptible et sans verrouillage (T1o, T2o, T3o ; T1u, T2u, T3u) est désaturé.

6. Procédé selon la revendication 1, dans lequel l'élévation de la valeur inférieure (U_{CEref2}) de la tension de limitation de référence (U_{CEref}) à la valeur prédéterminée (U_{CEref1}) de la tension de limitation de référence (U_{CEref}) commence dès que la valeur d'une tension grille-émetteur (U_{GE}) déterminée a diminué à la valeur d'une tension de plateau.

7. Procédé selon la revendication 1, dans lequel l'élévation de la valeur inférieure (U_{CEref2}) de la tension de limitation de référence (U_{CEref}) à la valeur prédéterminée (U_{CEref1}) de la tension de limitation de référence (U_{CEref}) commence dès qu'un temps d'attente prédéterminé s'est écoulé.

8. Procédé selon l'une des revendications 1 à 7, dans lequel on diminue la valeur de la tension de limitation de référence (U_{CEref}) de telle sorte que le circuit de limitation collecteur-émetteur actif des interrupteurs à semiconducteur de puissance (T1o, T2o, T3o ; T1u, T2u, T3u) interruptibles, sans verrouillage et branchés en série, de la soupape de convertisseur interruptible répond.

9. Procédé selon l'une des revendications 1, 5 à 8, dans lequel on diminue de façon continue la valeur prédéterminée (U_{CEref1}) de la tension de limitation de référence (U_{CEref}) à une valeur inférieure (U_{CEref2}) de la tension de limitation de référence (U_{CEref}).

10. Procédé selon l'une des revendications 1, 5 à 8, dans lequel on augmente de façon continue d'une valeur inférieure (U_{CEref2}) de la tension de limitation de référence (U_{CEref}) à la valeur prédéterminée (U_{CEref1}) de la tension de limitation de référence (U_{CEref}).

11. Procédé selon l'une des revendications précédentes, dans lequel la valeur inférieure (U_{CEref2}) de la tension de limitation de référence (U_{CEref}) est déduite d'une tension continue de circuit intermédiaire (U_{d}) déterminée.

12. Dispositif pour la commande d'une soupape de convertisseur interruptible comportant au moins deux interrupteurs à semiconducteur de puissance (T1o, T2o, T3o ; T1u, T2u, T3u) interruptibles, sans verrouillage et branchés électriquement en série, qui comportent chacun un étage d'attaque (4) et un circuit de blocage (6) comme circuit de limitation collecteur-émetteur actif, dans lequel ce circuit de blocage (6) est branché entre une borne de collecteur (C) et une borne de commande (G) d'un interrupteur à semiconducteur de puissance (T1o, T2o, T3o ; T1u, T2u, T3u) associé, dans lequel l'étage d'attaque (4) à l'entrée de commande duquel se trouve un signal de commande (U_{ASt}) est relié en sortie à une borne de grille (G) d'un interrupteur à semiconducteur de puissance (T1o, T2o, T3o ; T1u, T2u, T3u) associé et dans lequel au moins une diode Zener (V1, V2) peut être court-circuitée au moyen d'un interrupteur (8) qui est relié côté commande à un dispositif (10) pour la génération de deux signaux de commande (S_{E}, S_{A}) à partir d'un signal de commande appliqué (U_{ASt}), le signal de commande (S_{E}) pour la fermeture de l'interrupteur (8) étant déduit d'un front montant du signal de commande (U_{ASt}) et le signal de commande (S_{A}) pour l'ouverture de l'interrupteur (8) étant déduit d'un front descendant du signal de commande (U_{ASt}).

13. Dispositif pour la commande d'une soupape de convertisseur interruptible comportant au moins deux interrupteurs à semiconducteur de puissance (T1o, T2o, T3o ; T1u, T2u, T3u) interruptibles, sans verrouillage et branchés électriquement en série, qui comportent chacun un étage d'attaque (4) et un circuit de limitation collecteur-émetteur actif comportant un dispositif de détection de tension (16), dans lequel un amplificateur différentiel (12) est prévu comme circuit de limitation collecteur-émetteur actif, dans lequel le dispositif de détection de tension (16) est relié en entrée à une borne de collecteur (C) d'un interrupteur à semiconducteur de puissance (T1o, T2o, T3o ; T1u, T2u, T3u) associé et en sortie à une entrée de valeur réelle de l'amplificateur différentiel (12) qui est relié en sortie à une entrée de commande de l'étage d'attaque (4), dans lequel une entrée de référence de l'amplificateur différentiel (12) peut être reliée au moyen d'un commutateur (24) à une première et à une deuxième source de tension de référence (18, 22), dans lequel il y a un signal de commande (S_{E}, S_{A}) à l'entrée de commande du commutateur (24) et dans lequel le signal de commande (S_{E}) pour la liaison de l'entrée de référence de l'amplificateur différentiel (12) à la deuxième source de tension de référence (22) est déduit d'un front montant d'un signal de commande (U_{ASt}) appliqué à l'entrée de commande de l'étage d'attaque (4) et le signal de commande (S_{A}) pour la liaison de l'entrée de référence de l'amplificateur différentiel (12) à la première source de tension de référence (18) est déduit d'un front descendant de ce même signal de commande (U_{ASt}).

14. Dispositif pour la commande d'une soupape de convertisseur interruptible comportant au moins deux interrupteurs à semiconducteur de puissance (T1o, T2o, T3o ; T1u, T2u, T3u) interruptibles, sans verrouillage et branchés électriquement en série, qui comportent chacun un étage d'attaque (4) et un circuit de limitation collecteur-émetteur actif comportant un dispositif de détection de tension (16), dans lequel un amplificateur différentiel (12) est prévu comme circuit de limitation collecteur-émetteur actif, dans lequel le dispositif de détection de tension (16) est relié en entrée à une borne de collecteur (C) d'un interrupteur à semiconducteur de puissance (T1o, T2o, T3o ; T1u, T2u, T3u) associé et en sortie à une entrée de valeur réelle de l'amplificateur différentiel (12) qui est relié en sortie à une entrée de commande de l'étage d'attaque (4), dans lequel une entrée de référence de l'amplificateur différentiel (12) est reliée à une source de tension de référence (18), dans lequel une source de courant commandable (26) est reliée en sortie au moyen d'un interrupteur (28) à une entrée de valeur réelle de l'amplificateur différentiel (12) et dans lequel cet interrupteur (28) est relié côté commande à un dispositif (10) pour la génération de deux signaux de commande (S_{E}, S_{A}) à partir d'un signal de commande appliqué (U_{ASt}), le signal de commande (S_{E}) pour la fermeture de l'interrupteur (28) étant déduit d'un front montant du signal de commande (U_{ASt}) et le signal de commande (S_{A}) pour l'ouverture de l'interrupteur (28) étant déduit d'un front descendant du signal de commande (U_{ASt}).

15. Dispositif selon l'une des revendications 12 à 14, dans lequel il est prévu un dispositif de surveillance grille-émetteur (30) et un circuit logique (32) qui est monté du côté aval du dispositif de surveillance grille-émetteur (30) et dans lequel un signal de commande (U_{ASt}) est appliqué à l'entrée de commande de ce circuit logique (32) et un signal de commande pour le circuit de limitation collecteur-émetteur actif se trouve à la sortie de commande de ce circuit logique.

16. Dispositif selon la revendication 13, dans lequel un régulateur mélangeur est prévu comme commutateur (24).
